# EUROPEAN PATENT APPLICATION

(11) **EP 0 993 023 A1**
(43) Date of publication of application: **12.04.2000**
(21) Application number: 98203341.7
(22) Date of filing: 05.10.1998
(51) Int. Cl.: H01L 21/00

(54) **Method for transferring a web-or sheet-like material into a clean room**

(71) Applicant: AGFA-GEVAERT N.V., 2640 Mortsel (BE)
(72) Inventor: Verlinden,Bart, c/o Agfa-Gevaert NV,IIE 3811, 2640 Mortsel (BE); Goedeweeck,Rudi, c/o Agfa-Gevaert NV,IIE 3811, 2640 Mortsel (BE)

(57) **Abstract**

An apparatus, an example of which is illustrated in the figure, is used to transfer a web- or sheet-like material from an outside environment into a clean room and to simultaneously carry out a cleaning step on said material. The construction of the apparatus allows to maintain an excellent boundary between the controlled atmosphere in the clean room and the outside environment. The apparatus comprises at least one treatment cell (12²) having a housing (16), a material inlet (18) and a material outlet (20), each said inlets (18, 20) being closed by a pair of rotatable path-defining rollers (26, 28) biased into contact with each other to form a nip (30) through which the material path (14) extends, and further comprises sealing means (32, 33, 34) to seal each path-defining roller (26, 28) to said housing (16). The cell is preferably filled with a cleaning liquid or other cleaning means.

## Description

### FIELD OF THE INVENTION

The present invention relates to a method for cleaning a web-or sheet-like material and simultaneously transferring said material into a clean room.

### BACKGROUND OF THE INVENTION

Typical methods for producing semiconductor devices require the use of clean rooms to minimise the damage caused by the presence of contamination particles. Present semiconductor processing methods employ submicron geometries and therefore demand stringent clean room conditions. A particular problem associated with clean rooms is that the transfer of materials such as wafers from the outside environment into the clean room may introduce contaminants and deteriorate the atmospheric cleanliness of the clean room.

A number of transport systems have thus been proposed to minimise the contamination associated with the transfer of materials into the semiconductor processing equipment. A standardised mechanical interface (SMIF) system has been proposed by the Hewlett-Packard Company as disclosed in U.S. Pat. Nos. 4,532,970 and 4,534,389. A SMIF system ensures that during transportation and storage the gaseous media (such as air or nitrogen) which surround the wafers is essentially stationary relative to the wafers and by ensuring that particles from the ambient environment do not enter the immediate wafer environment. The SIMF concept is based on the realisation that a small volume of controlled (with respect to motion, air flow and external contaminants), particle-free air provides a clean miniature environment around the wafers. A SIMF system comprises basically a sealed box, which holds the wafer cassettes and is provided with a door that can be docked to the doors on the the interface ports of the processing equipment.

Conventional SIMF pods have the potential to create particles due to physical scraping of the latch mechanismes which open the doors. Many other disadvantages of conventional SIMF systems are described in U.S. Pat. No. 5,628,683, which discloses an improved SIMF system. U.S. Pat. No. 5,651,797 describes an apparatus for the simultaneous immersion cleaning and transport of semiconductor components into a clean room. A cleaning tank, which holds a cleaning liquid and ultrasonic transducers, is constructed to serve as an entryway into a bounded clean room. The tank basically is provided with two doors, each located at one end of the tank. A first door enables to introduce a material from the outside environment into the tank. The material is then transported along the length of the tank through the cleaning liquid. The second door, which extends beyond the boundary of the clean room, permits the removal of material from the tank into the controlled atmosphere of the clean room. Both doors are never opened simultaneously and a positive pressure gradient from the clean room to the outside environment aids in reducing the opportunity for particles to enter the cleaning liquid or the clean room. The latter system is well suited for cleaning and transporting bulky equipment components into a clean room.

However some processes require the continuous supply of a web-or sheet-like material from the outside environment into a clean room, e.g. when two substrates are to be laminated together in a dust-free environment so as to minimise the presence of particles between the constituting layers of the laminate. The above methods use essentially batch systems and the cumbersome process of opening and closing doors of clean room locks is unsuitable when a web- or sheet-like material needs to be transported into the clean room in a continuous (web) or semi-continuous (sheet by sheet) way.

### SUMMARY OF THE INVENTION

It is an object of the present invention to provide an improved method of effecting the transport of a web- or sheet-like material between a clean room and an outside environment with an extremely low risk of contamination of the clean room. It is another object of the present invention to provide said method in such a way that said transport can be carried out continuously in contrast to the batch methods known in the prior art. It is still another object of the present invention to provide said method in such a way that a cleaning step to remove contamination particles from the surface of said material can be carried out simultaneously with said transport.

The above mentioned object is realised by the method using the apparatus defined in claim 1. Specific features of preferred embodiments of the invention are disclosed in the dependent claims. Further advantages and embodiments of the present invention will become apparent from the following description and drawings.

### BRIEF DESCRIPTION OF THE DRAWINGS

Figure 1 shows a diagrammatical cross-section of one embodiment of the apparatus used in the method of the present invention, wherein the material path is horizontal and an intermediate region is present between adjacent cells;
Figure 2 shows a diagrammatical cross-section of another embodiment of the apparatus used in the method of the present invention, wherein the material path is vertical and no intermediate region is present between adjacent cells;
Figure 3 is an enlarged view of one end of the path-defining roller pair of the apparatus shown in Figure 2; and
Figure 4 is a view similar to Figure 3, with one path-defining roller in a partly dis-assembled state.

### DETAILED DESCRIPTION OF THE INVENTION

The method of the present invention uses an apparatus similar to the device for processing photographic material which has been described in EP-A 789 276, filed by the same applicant as the present application. The apparatus is preferably integrated in the clean room wall which insulates the controlled atmosphere from the outside environment and is used as a transfer system as well as a cleaning device for contamination-free transport of a web- or sheet-like material from the outside environment into the clean room or vice-versa (in the latter case, the treatment cells are not necessarily filled with cleaning liquid).

Said apparatus comprises at least one treatment cell having a housing, a material inlet and a material outlet, each said inlets being closed by a rotatable path-defining roller pair biased into contact with each other to form a nip through which the material path extends, and further comprising sealing means to seal each said path-defining roller to said housing. The material inlet allows the introduction of the material from the outside environment into the treatment cell of the apparatus. While being transported through the treatment cell, the material is cleaned and then leaves the cell at the material outlet which is accessible from within the clean room. By providing a gas- and liquid-tight seal between the rollers on the one hand and a wall of the housing on the other, the penetration of contamination particles in the apparatus is minimised.

In a highly preferred embodiment, at least one cell is filled with a cleaning liquid, which may be one of the known compositions for cleaning the material, e.g. organic solvents, aqueous solutions of surfactants, acids or bases, etching agents, etc. The treatment cell of said preferred embodiment may further comprise liquid level control means to define a static liquid level above the material path. A even more preferred method according to the invention uses an apparatus, wherein said housing includes a treatment liquid circulation passage located below said static liquid level and wherein an upper portion of said housing includes means to facilitate depressurising said cell so as to enable easy filling of the cell. The means to define a static liquid level above the material path may comprise a treatment liquid overflow provided in the housing at a level above the material path. Treatment liquid passing through the overflow may be recycled if desired. Alternatively or additionally, the apparatus may further comprise sensing means for sensing the level of treatment liquid in the cell and control means, responsive to the output of the sensing means, to adjust the level of treatment liquid in the cell to a predetermined level.

Alternatively, the apparatus may also comprise one or more alternative treatment cells, e.g. a cell which is provided with an ultrasonic transducer, a (rotatable) brush, a scraper, means for spraying a treatment liquid directly onto the material, means for acting upon the rollers to remove debris therefrom, e.g. as described in EP-A 647 882, or any other cleaning means known in the art. The cell may also constitute intermediate buffer cells where diffusion reactions take place on the material prior to contact with treatment liquid in the next adjacent cell.

Preferably, the material is dried after being cleaned, e.g. by providing the last treatment cell along the material path with drying means, e.g. a hot-air dryer, a microwave dryer or an infrared dryer. It is self-evident that the air supply of the dryer is preferably withdrawn from the clean room atmosphere.

Before turning to the construction details of the apparatus, its use according to the method of the present invention will be discussed.

The apparatus is especially suitable for cleaning and transporting a plurality of web- or sheet-like materials into a clean room for making a laminate in dust-free conditions so as to minimise lamination artefacts. The term "laminate" as used herein shall be understood as "a material consisting of a plurality of bonded materials". The materials may be bonded to each other by applying an intermediate adhesive layer between said bonded materials but also vacuum lamination can be used. Lamination can be effected manually but preferably is effected in a laminating means called a laminator. A typical laminator comprises a pair of heatable rollers, having an adjustable pressure and moving at a fixed or an adjustable speed. The lamination is effected by bringing the materials in close contact with each other, optionally by applying an adhesive between the materials before being put through between the rollers of the laminator.

Accordingly, a preferred method for making a laminate according to the present invention comprises the steps of
- cleaning and transporting a first web- or sheet-like material from an outside environment into a clean room using an apparatus according to the present invention;
- cleaning and transporting a second web- or sheet-like material from an outside environment into said clean room using an apparatus according to the present invention;
- laminating said first material to said second material inside said clean room.

A particularly preferred laminate, that may be produced by this method is a flexible laminate comprising a plastic support and a thin glass substrate as constituting layers. The thin glass is preferably chemically hardened sodium glass or borosilicate glass having a thickness below 500 µm. A highly preferred glass/plastic laminate has been described in patent application PCT\EP98\05748, filed on the 9th of September, 1998.

In addition to the above lamination method, it is clear for the skilled reader that the method of the present invention is applicable to many other clean room processing steps. It shall be understood that the term "sheet-like" embraces any flat form such as a rectangular sheet, a square sheet, a disc, a wafer, etc. The thickness of the material is preferably lower than 2 mm, and more preferably lower than 500 µm. The web or sheet-like material may comprise a stiff layer such as a glass sheet or a semiconductor slice. Accordingly, the material path in the apparatus is preferably substantially rectilinear. A rectilinear path is independent of the stiffness of the material and reduces the risk of scratching compared with a circuitous path.

The apparatus may have a substantially horizontal configuration, where the sheet material is transported along a generally horizontal path, the sheet material passing from one cell to another under the surface of treatment liquid present in one or more cells. The apparatus alternatively may have a substantially vertical orientation, in which a plurality of cells are mounted one above the other, each cell having an opening at the top acting as a sheet material inlet and an opening at the bottom acting as a sheet material outlet or vice versa.

The web- or sheet-like material may also be a flexible material, enabling the use of a combined horizontal-vertical configuration or even a circuitous configuration of the apparatus. Examples of such flexible material are (coated) paper, a metal foil, a thin glass as described above, or a plastic material such as poly(ethylene therephtalate), polycarbonate, polyethylene etc. Said flexible material is preferably supplied as a web, wound around a core. By unwinding the web from its core, the material can be supplied continuously into the apparatus.

Alternatively, the material can also be supplied sheet by sheet, either manually or mechanically. Whatever the supply method used, the construction of the apparatus guarantees an excellent boundary between the controlled clean room atmosphere and the outside environment and in addition allows to carry out a flexible, multi-purpose cleaning process, which is executed simultaneously with the transfer of the material from said outside environment into the clean room.

The method of the present invention is highly suitable in the manufacturing process of semiconductor devices. A particular field which may benefit from the method is the manufacturing of flat-panel displays, such as liquid crystal displays (LCDs), e.g. ferro-electric LCDs, super-twisted nematic (STN) LCDs, thin-film-transistor (TFT) LCDs, etc. In such LCDs a glass sheet, a plastic support or a glass/plastic laminate can be used as a substrate for carrying the electronic components and necessary functional layers, e.g. colour filter layers, liquid crystal orientation layers, indium-tin oxide electroconductive layers, etc. Said electronic components and functional layers need to be deposited on the substrate in clean room conditions. This manufacturing process is typically a batch process (sheet by sheet). By using a flexible substrate such as the glass/plastic laminate, discussed above, in the method of the present invention, continuous roll-to-roll manufacturing of flexible displays is enabled.

The specific features of the apparatus used in the present invention will now be discussed. The housing of the apparatus is a static structure of which side plates support rollers. The path-defining rollers are used in pairs, biased towards each other so as to form a nip, between which the sheet material passes. Said nip acts as a boundary between the interior and the exterior of the treatment cell. The cell further comprises sealing means to seal each path defining roller to the housing.

First the path-defining roller will be described in more detail. In a preferred embodiment of the apparatus, the path-defining rollers are substantially equal in length. One or both of the path-defining rollers may constitute drive rollers for driving the material along the material path. Alternatively, the path-defining rollers may be freely rotating, alternative drive means being provided to drive the through the apparatus.

To achieve a proper boundary between the interior and exterior of the cell, the rollers are preferably resilient rollers which exert a sufficient and homogeneous pressure over the whole width of the material. In this way, liquid carried on the material as it leaves a treatment cell is removed efficiently so as to prevent carry-over of liquid into a next treatment cell. Also, to reduce edge effects, it is desirable that the opposite roller surfaces are in contact which each other beyond the edges of the material.

Preferably the path-defining rollers have a core which is provided with a covering of elastomeric material, although it is possible for the roller to be elastomeric throughout its cross-section. In view of the nature of elastomeric material, it is in fact impossible to totally eliminate any gap between the roller surfaces at the edges of the material as it passes through the nip. It is desirable that the roller surfaces be in contact with each other within as short a distance as possible from the edges of the material i.e. that the size of the leak zone should be minimised. It is important that the force between the rollers is sufficient to prevent leakage when no material is passing through. However, the force may not be so high as to risk physical damage to the material as it passes through the nip. A load in the order of 0.001 to 1.0 N/mm roller length, preferably 0.025 - 0.5 N/mm may be applied.

The objective of a minimum leak zone referred to above can be achieved if the ratio of the diameter of the roller to its length is above a critical limit. According to a preferred embodiment of the apparatus, at least one of the rollers, and preferably each roller, comprises a rigid core carrying a covering of elastomeric material, the ratio (φ/L) of the maximum diameter (φ) of the elastomeric material covering to the overall length (L) thereof being at least 0.012, most preferably between 0.03 and 0.06. It is preferred that the roller requirements referred to above apply to the second roller also. Indeed, it will be usual for the two rollers to be identical, although it is possible that the diameters (φ), and therefore the ratios (φ/L), of the two rollers need not be identical.

The elastomeric material covering preferably has a thickness of between 1 mm and 30 mm. The elastomeric material may be selected from ethylene/propylene/diene terpolymers (EPDM), silicone rubber, polyurethane, thermoplastic rubber such as Santoprene (Trade Mark for polypropylene/EPDM rubber), styrene-butyl rubber and nitrile-butyl rubber. The hardness of the elastomeric material may be between 10 shore (A) and 90 Shore (A), as measured on the roller surface. In one embodiment of the apparatus, the diameter (φ) of the elastomeric material covering is constant along the length of the roller. Alternatively the roller may have a radial dimension profile which varies along the length thereof. In the latter case, the diameter (φ) in the expression φ/L is the maximum diameter. In a preferred embodiment, such a roller comprises a non-deformable core, the thickness of the elastomeric material covering varying along the length thereof. Alternatively or additionally, the diameter of the core varies along the length thereof.

Ideally, the radial dimension profile of such a roller is such in relation to the force applied by the roller to material passing through the nip as to be substantially even over the width thereof. The radial dimension of the roller ideally decreases towards the ends thereof i.e. a convex profile, especially a parabolic profile. Preferably, the core has a flexural E-modulus of between 50 GPa and 300 Gpa. Suitable materials for the rigid core include metals, such as stainless steel, non-ferrous alloys, titanium, aluminium or a composite thereof or a composite material of fibres such as carbon fibres and a resin matrix.

In one embodiment of the apparatus, the core is hollow, in order to reduce the weight thereof. Alternatively the core may be solid, thereby to improve the strength thereof. In a preferred embodiment of the apparatus, the rollers are substantially equal in length. Where the rollers are of different lengths, and/or are offset, the length of the nip between them is less than the roller length. In this case it is preferred that the ratio of the roller diameter φ to the length of the nip is greater than 0.012.

The rollers may be biased together by a variety of methods. The rollers may be biased together for example by making use of the intrinsic elasticity of the elastomeric material, by the use of fixed roller bearings. Alternatively, use may be made of resilient means such as springs which act on the ends of the roller shafts. The springs may be replaced by alternative equivalent compression means, such as e.g. a pneumatic or a hydraulic cylinder.

The path-defining roller may be a small diameter, light weight roller comprising a core provided with a covering of relatively soft material, having an effective length (λ) of from 0.4 to 2.0 m, the core having a maximum diameter (φ) of less than 0.04*λ m. The effective length of the roller (λ) is defined as the length of that part of the core which is covered with the relatively soft covering, minus 0.02 m at each side. This allows for the fact that, in practise, the roller is not supported at its absolute ends, but rather at points situated just before each end. For similar reasons, the weight of the roller is defined as the weight of the core and the covering, cut to the effective length λ, without spindles or bearings.

At least one of the path-defining rollers may comprise an inner region of elastomeric material having a relatively low hardness, and an outer region of elastomeric material having a relatively high hardness positioned over the inner region. The two regions of elastomeric material will usually be constituted by distinguishable layers, but it is also possible to use a single layer of elastomeric material which is so formed to have a hardness which varies throughout its thickness.

It is preferred that both the path-defining roller comprise the inner region of elastomeric material having a relatively low hardness, and the outer region of elastomeric material having a relatively high hardness positioned over the inner region. The Shore-A hardness of the inner region may be less than 50, preferably from 15 to 45, while the Shore-A hardness of the outer region may be more than 25, preferably from 40 to 90. Where the inner and outer regions are constituted by distinguishable layers, the difference between the Shore-A hardness of the inner layer and the outer layer may be at least 5, most preferably at least 10. Elastomeric materials having a low Shore-A hardness provide elastomeric properties consistent with the objective of low carry-over, but low molecular weight compounds tend to diffuse in use into the treatment liquids so that these elastomeric properties are lost while both chemical and physical wear resistance are low. The provision of the outer region of elastomeric material having a higher Shore-A hardness reduces these negative effects, surprisingly without significantly increasing carry-over and enables grinding to a desired surface quality. More specifically, optimal grinding of the elastomeric material improves the hydrophilicity of the material by stabilising its surface roughness and also reduces the torque required to drive the roller by lowering its rolling resistance. The use of elastomeric materials with relatively high hardness improves the stability to oxygen and ultra violet light, reduces evaporation of elastomeric compounds from the surface and reduces the diffusion of treatment liquids through the material. The performance and useful life of the roller can therefore be optimised.

Where the inner and outer regions are constituted by distinguishable layers, the inner layer may have a thickness which may be from 5% to 35%, such as from 10% to 20% of the roller diameter, that is at least 1.0 mm, such as from 4 mm to 8 mm for a typical roller having a diameter of 40 mm. The outer layer may have a thickness which may be from 1% to 10% of the roller diameter, that is at least 0.2 mm for the typical roller. Below this thickness, the elastomeric effect may be lost, and grinding to a desired profile becomes difficult or impossible. Such rollers exhibit good stability against treatment liquids.

Each path-defining roller may comprise an outer region of elastomeric material, at least a portion of which contains potassium titanate whiskers. The potassium titanate whiskers are known in the art as TISMO which is generally expressed by the formula K₂O.nTiO₂, especially TISMO D (n = 8). It is a microfine whisker having a typical whisker diameter of from 0.3 to 0.6 µm and a whisker length of from 10 to 20 µm.

Next, the sealing means will be discussed. The sealing means may comprise a rotatable sealing member, such as a sealing roller, or a stationary sealing member, said rotatable or stationary sealing member being in contact with the rotatable path-defining roller along its length. A rotatable sealing member is preferred because the torque which needs to be applied to the path-defining rollers can be significantly reduced. This reduces the power needed by the apparatus, reduces wear on the path-defining rollers, reduces the mechanical deformation thereof and thereby extends the expected life time. This construction also improves the control of pressure distribution over the sheet material.

The rotatable sealing member preferably comprises a sealing roller, and in particular the sealing roller may have a diameter less than that of the path-defining roller. For example, the sealing roller may have a diameter which is from one tenth to one third of the diameter of the path-defining roller, thereby enabling the torque which needs to be applied to be further reduced. The sealing roller preferably extends in a straight line parallel to the associated path-defining roller axis and preferably contacts the surface of the associated path-defining roller at a location which is between 45° and 315°, most preferably between 135° and 225° from the centre of the nip, on the fluid side. It is also possible to employ two or more such sealing rollers in association with each path-defining roller.

The sealing roller may be formed of a material having a coefficient of friction (as measured against stainless steel) of less than 0.3, preferably from 0.05 to 0.2, for example highly polished metals such as steel, especially Cr-Ni steel and Cr-Ni-Mo steel, a metal coated with Ni-PTFE (NIFLOR - Trade Mark), a polymer material such as PTFE (poly tetra fluoro ethylene), POM (polyoxymethylene), HDPE (high density polyethylene), UHMPE (ultra high molecular weight polyethylene), polyurethane, PA (polyamide), PBT (polybutyl terephthalate) and mixtures and composites thereof.

In a preferred embodiment, the sealing roller is carried by a longitudinal bearing, constituting a stationary sealing member secured within the housing.

The sealing means preferably also include a sealing member at each end of a roller to prevent leakage or contamination between the roller and the side plate of the housing.

In one embodiment of the apparatus, the path-defining rollers are mounted between the side plates in the cell, with shafts fixed to the core and extending from each end thereof. End members, in contact with the covering and an adjacent side plate, are mounted on the shafts in a replaceable manner.

In another embodiment of the invention however, the sealing rollers are mounted between the side plates in the cell and in sealing contact with the path-defining rollers, the sealing rollers comprising a main body member with shafts fixed to the main body member and extending from each end thereof. End members in contact with the main body member and an adjacent side plate can be mounted on the shafts in a replaceable manner. In this manner, the ends of the sealing roller are in contact in a leak-free manner with the side plates.

Where end members for both the path-defining rollers and the sealing rollers are provided, it is preferred that the pressure between the side plate and the end members in contact therewith is substantially identical. This can be achieved where the axial dimension of the end member associated with the sealing roller is greater than the axial dimension of the end members associated with the path-defining rollers. This difference takes account of the rigid nature of the sealing roller main body member and the relatively resilient elastomeric covering of the path-defining roller.

Usually each cell of the apparatus is constructed as aforesaid. However, some cells may be of different construction. Additional rollers, such as a roller pair or staggered rollers may be provided for transporting the material through the apparatus, and these rollers will normally be driven rollers. Additional roller pairs may be provided for breaking the laminar fluid at the surface of the material as it passes through the apparatus, and these rollers may be driven rollers or freely rotating rollers. Guide means may be included for guiding the passage of the material through the apparatus. Heating means may be provided in one or more cells so that the cell becomes a material drying unit, rather than a wet treatment unit. While liquid pumping, heating, cooling and filtering facilities will normally be provided outside the cells, it is possible for some elements of these features to be included in the cells themselves. Any combination of these additional features is also possible.

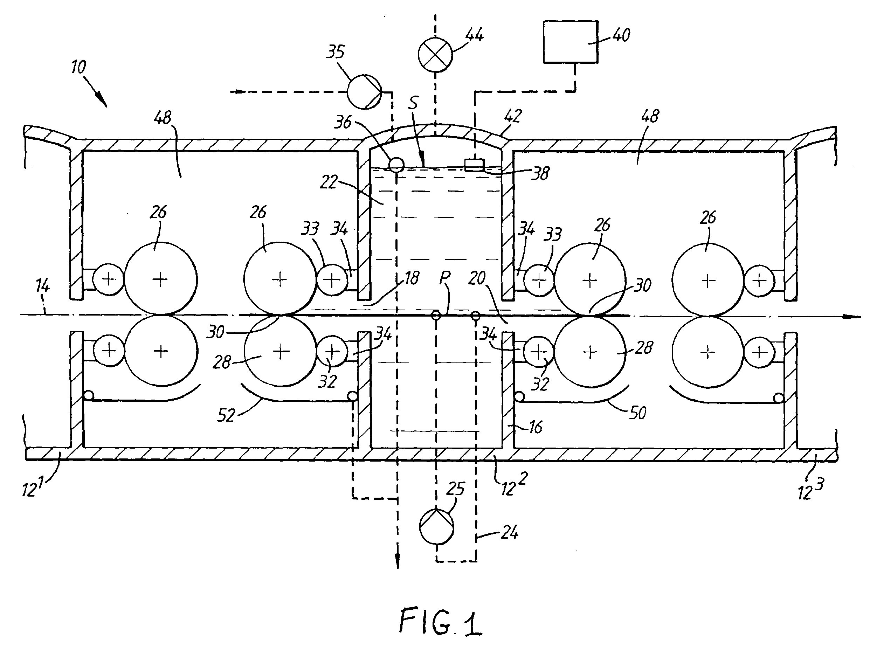

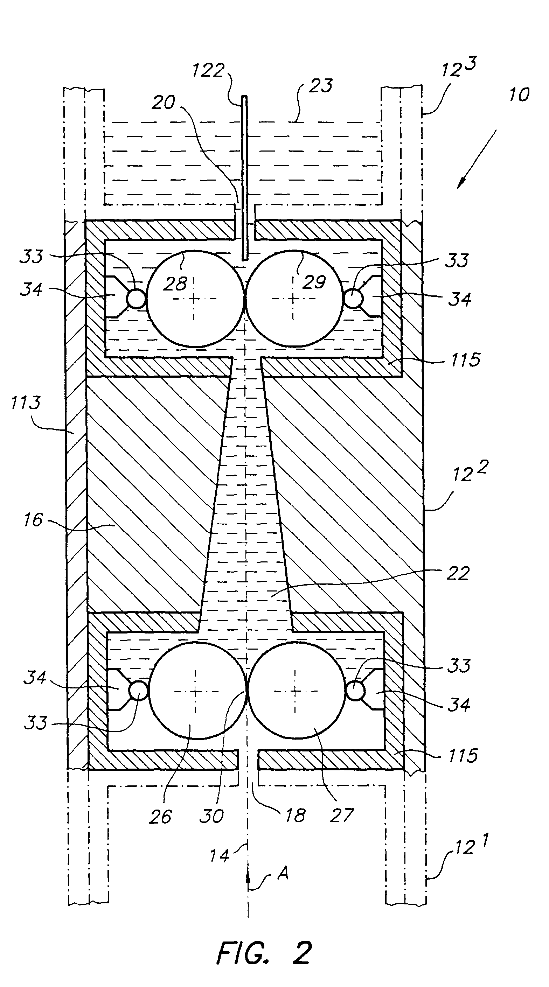

Each cell is connected to optional adjacent cells in the apparatus in a closed manner. By the term "closed manner" in this specification is meant that each cell is so connected to adjacent cells that no cell is open to the environment. In one embodiment of the apparatus, a particular path-defining roller pair may act as an outlet of one cell and simultaneously as an inlet of the adjacent cell (as shown in figure 2) . In another, preferred embodiment, a cell may be spaced from the next adjacent cell by a closed intermediate region (as shown in figure 1). It may also be advantageous to provide a closed entry region in advance of the first treatment cell and/or a closed exit region following the final treatment cell, thereby to protect the treatment cells from the environment.

Preferably, a first drip tray is provided in the intermediate region below the nip of the material outlet of the one cell and a second drip tray is provided in the intermediate region below the nip of the material inlet of the next adjacent cell.

Each cell may be of modular construction and provided with means to enable the cell to be mounted directly beside an identical or similar other cell. Alternatively, the apparatus may take an integral or semi-integral form in which the means for connecting each cell to adjacent cells in a closed manner is constituted by common housing walls of the apparatus. By the term "semi-integral form" we intend to include an apparatus which is divided by a substantially horizontal plane passing through all the vessels in the apparatus, particularly the plane of the material path, enabling the apparatus to be opened up for servicing purposes, in particular to enable easy access to the rollers.

In a preferred method according to the present invention, the apparatus comprises a plurality of treatment cells mounted one beside another to define a substantially horizontal material path through the apparatus and wherein at least one cell comprises a treatment liquid. The material is preferably fed into the apparatus at a level below the static liquid level. It is preferable that, during operation of the apparatus, the dynamic liquid level is also above the material path. Uniform cleaning of the material can thereby be assured.

The apparatus may be cleaned from time to time by draining treatment liquids from the cells, optionally to a storage container for later re-use, adding cleaning liquid, such as wash water, to one of the cells, and pumping such cleaning liquid to the other cells in the apparatus in turn. Such a cleaning method makes economical use of the cleaning liquid.

The apparatus according to the invention may be adapted in that means are provided to circulate the treatment liquids (including wash water) through the treatment cells. Ideally, the circulation passage withdraws treatment liquid from the cell and returns it again to the cell approximately at the level of the material path. Preferably, the treatment liquid is filtered before being returned to the cell so as to remove particles from the liquid.

The apparatus may further comprise means to maintain the treatment liquids at a predetermined temperature. Such an apparatus may be operable in at least two selectable modes. In a "standby" mode the treatment liquids are maintained at their respective predetermined temperatures. In an "operating" mode additionally the treatment liquid is circulated through the treatment cell or cells, material is driven through the apparatus and the drying unit is operated.

The method according to the invention may include a measuring step in which the throughput of material through a given cell over a given period of time is measured, a regeneration step in which fresh treatment liquid is added to that cell in an amount calculated from the measured throughput of material to maintain the concentration of active ingredients in that cell substantially constant by weight, and a top-up step in which further fresh treatment liquid is added to that cell to compensate for any loss in treatment liquid level within that cell.

The invention will now be described by the following illustrative embodiments with reference to the accompanying drawings without the intention to limit the invention thereto. As shown in Figure 1, an apparatus 10 comprises a plurality of treatment cells 12¹, 12², 12³ mounted one beside another to define a substantially horizontal material path 14 through the apparatus. In Figure 1, cells 12¹, and 12³ are only partly shown. The material path 14 through the cells 12¹, 12², 12³ is substantially straight. Referring in particular to cell 12², it is made clear that each cell comprises a housing 16 having a material inlet 18 and a material outlet 20. Treatment liquid 22 having a static liquid level S is retained in the cell. The housing 16 includes a treatment liquid circulation passage 24 located below the static liquid level S, liquid flow through the circulation passage being controlled by a circulation pump 25.

The inlet 18 and the outlet 20 are each closed by a pair of rotatable path-defining rollers 26, 28. One of the path-defining rollers 26, 28 of each pair constitutes a drive roller for driving the material along the material path 14. The path-defining rollers 26, 28 are biased into contact with each other to form a nip 30 through which the material path 14 extends, thereby defining a nip plane (P).

Sealing rollers 32 in contact with the rotatable path-defining rollers 28 along the length thereof, are provided to seal each path-defining roller 28 to the housing 16. Similarly, sealing rollers 33 in contact with the path-defining rollers 26 seal the latter to the housing 16. Each sealing roller 32, 33 is carried by a longitudinal bearing 34 constituting a stationary sealing member which seals the sealing roller to the housing 16. The sealing rollers 32, 33 contact the respective path-defining rollers 28, 26 at a position located 90° from the nip 30 on the liquid side.

A treatment liquid is fed to the cell by a pump 35. An overflow 36 provided in the housing 16 at the level S above the nip plane P is provided to define a static liquid level S above the nip plane P. Sensing means 38 are provided for sensing the level S of treatment liquid 22 in each the cell. Control means 40, responsive to the output of the sensing means 38, serve to adjust the level S of treatment liquid 22 in the cell to the required level S, by controlling the operation of the pump 35. The housing 16 includes an upper portion 42 which includes a closeable valve 44, which can be opened to facilitate depressurising the cell.

Each cell is spaced from the next by a closed intermediate region 48. A first drip tray 50 is provided in the intermediate region below the nip 30 of the material outlet 20 and a second drip tray 52 is provided in the intermediate region below the nip 30 of the material inlet 18. Treatment liquid recovered from the drip trays 50, 52 may be recirculated.

The apparatus of figure 2, 3 and 4 comprises a housing 16 having a lid 113 which can be removed for servicing purposes. A number of replaceable sub-housings or racks 115 are located within the housing 16 and serve to define a number of sequential treatment cells 12¹, 12², 12³, of which only cell 12² is shown in detail. Other cells may be similarly constructed. In contrast to the apparatus of figure 1, this apparatus defines a vertical material path 14 and contains no intermediate region between adjacent treatment cells.

The cell 12² has an inlet 18 and outlet 20 together defining a sheet material path 14 through the cell and path-defining rollers 26, 27, 28, 29 mounted between side plates 124 in the cell. The side plates 124 are screwed to the rack 115 by screws 125. Passages (not shown) through the housing 16 provide a supply and drain for the treatment liquid 22. The outlet defined by the upper roller pair 28, 29 simultaneously acts as an inlet for the next treatment cell 12³, the treatment liquids 22 and 23 being separated by said roller pair 28, 29 and sealing means 33 and 34, the latter being secured to the rack 115.

The path-defining rollers 26, 27, 28 and 29 are positioned substantially parallel and in line contact with each other. Each path-defining roller is fixed on a respective shaft 146 for rotation, the roller shafts 146 being mounted at each end in bearings (not shown) held in the rack 115. The roller shafts are biased towards each other to exert a pressure on the material as it passes between the path-defining rollers. Compression springs (not shown) bias the path-defining rollers towards each other with a force of up to 400 N at a roller length of about 850 mm into contact with each other to form a nip 30 there-between through which the sheet material path 14 extends. The path-defining rollers 26, 27, 28 and 29 are drive rollers driven by a drive device (not shown) to transport material 122 along the path 14 in the direction of arrow A.

Each of the path-defining rollers 26, 27, 28, 29 comprises a main roller body member 130 formed of a hollow stainless steel rigid core 131 and an elastomeric covering 132. The core 131 has an outside diameter of 25 mm and a wall thickness of 3 mm. The roller shaft 146 is suitably welded to the end of core 131, or is integral therewith. The elastomeric covering 132 is formed of EPDM and is secured to the core 131 by adhesive. The covering 132 has a circular cross-section, with a diameter of about 40 mm.

End members 134 are urged into in contact with the covering 132 and with adjacent side plates 124 secured to the rack 115. Each end member 134 is in contact with the elastomeric covering 132 and is mounted on the shaft 146 to rotate therewith. There is therefore no relative motion between the end member 134 and the elastomeric covering 132, thereby ensuring no wear of the elastomeric covering at this point. Rather, there is face-to-face relative movement between the end member 134 and the adjacent side plate 124. The force between the end members 134 and the side plate 124 can be adjusted by tightening or loosening of the screws 125.

The end member 134 comprises a rigid flat ring 136 formed of chrome-nickel alloy, embedded in elastomeric material 137 which is EPDM doped with approximately 30% by weight PTFE. The end member 134 has an outer diameter which is the same as the outer diameter of the corresponding end of the covering 132. The end member 134 is so shaped in relation to the core 131 as to provide a space 144 into which the elastomeric material of the covering 132 may be deformed as a result of a sealing force between the path-defining roller and the side plates 124.

The rigid flat ring 136 is so shaped as to fit over the roller shaft 146 in a manner to rotate therewith. To achieve this, the shaft 146 has an enlarged portion 138, located adjacent the end of the covering 132, having two opposite flat faces, while the shaft 146 is otherwise of generally of circular cross-section. The ring 136 has a correspondingly shaped aperture 142, enabling the end member to slide in the axial direction along the roller shaft 146 to be removed and replaced, while ensuring that the end member 134 rotates with the path-defining roller. The end meters 134 are thus mounted on the shaft 146 in a replaceable manner.

Each sealing roller 33 comprises a main sealing roller body member 231 formed of stainless steel and having a diameter of 20 mm. A sealing roller shaft 246 is suitably welded to the end of body member 231, or is integral therewith.

The end members 234 of the sealing rollers comprise elastic material 237 urged into in contact with the body member 231 and with adjacent side plates 124 secured to the rack 115. Each end member 234 is in contact with the main sealing roller body member 231 and is closely mounted on the shaft 246 to rotate therewith. There is therefore no relative motion between the end member 234 and the main body member 231, thereby ensuring no wear of the elastomeric covering at this point. Rather, there is face-to-face relative movement between the end member 234 and the adjacent side plate 124. The force between the end members 234 and the side plate 124 can be adjusted by tightening or loosening of the screws 125.

The end member 234 is formed in a similar manner to end member 134, that is it comprises a rigid flat ring 236, embedded in elastomeric material 237 which is doped with PTFE. The end member 234 has an outer diameter which is the same as the outer diameter of the corresponding end of the main body member 231.

The rigid flat ring 236 is so shaped as to fit over the roller shaft 246 in a manner to rotate therewith. To achieve this, the shaft 246 has an enlarged portion 238, located adjacent the end of the main body member 231, having two opposite flat faces, while the shaft 246 is otherwise of generally of circular cross-section. The ring 236 has a correspondingly shaped aperture 242, enabling the end member 234 to slide in the axial direction along the roller shaft 246 to be removed and replaced, while ensuring that the end member 234 rotates with the path-defining roller. The end members 234 are thus mounted on the sealing roller shaft 246 in a replaceable manner.

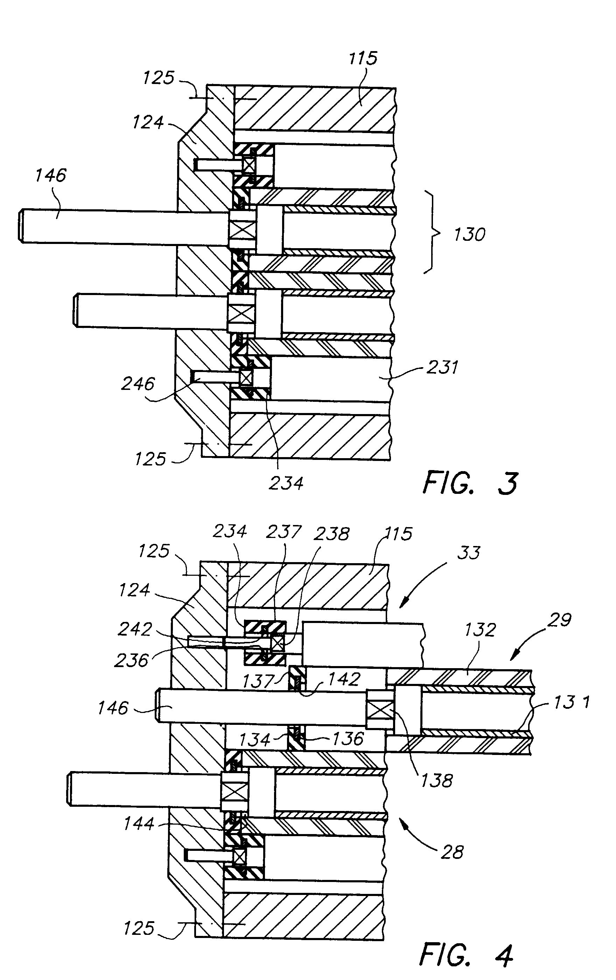

As can be seen from Figures 3 and 4, the axial dimension of the end members 234 associated with the sealing rollers 33 is greater than the axial dimension of the end members 134 associated with the path-defining rollers 26, 27, 28, 29. This difference takes account of the rigid nature of the sealing roller main body member 231 and the relatively resilient elastomeric covering 132 of the path-defining roller 26, 27, 28, 29. In this manner, it is assured that the pressure between the side plate 124 and the two end members 134, 234 is substantially identical.

### Reference Number List

apparatus 10
treatment cells 12¹, 12², 12³
sheet material path 14
housing 16
sheet material inlet 18
sheet material outlet 20
treatment liquid 22, 23
static liquid level S
circulation passage 24
circulation pump 25
path-defining rollers 26-29
nip 30
sealing rollers 32, 33
longitudinal bearing 34
pump 35
overflow 36
sensing means 38
control means 40
upper portion 42
closeable valve 44
intermediate region 48
1st drip tray 50
2nd drip tray 52
lid 113
rack 115
main roller body member 130
core 131
covering 132
end member 134
ring 136
elastomeric material 137
enlarged portion 138
aperture 142
space 144
shaft 146
sealing roller body member 231
end member 234
ring 236
elastomeric material 237
aperture 242
sealing roller shaft 246

## Claims

1. A method for cleaning a web- or sheet-like material and for transporting said material between an outside environment and a clean room along a material path (14), said apparatus comprising at least one treatment cell (12²) having a housing (16), a material inlet (18) and a material outlet (20), each said inlets (18, 20) being closed by a pair of rotatable path-defining rollers (26, 28) biased into contact with each other to form a nip (30) through which said material path (14) extends, and further comprising sealing means (32, 33, 34) to seal each said path-defining roller (26, 28) to said housing (16).

2. A method according to claim 1 wherein the material path (14) is substantially rectilinear.

3. A method according to claim 1 or 2 wherein the treatment cell contains a cleaning liquid.

4. A method according to any preceding claim, wherein the sealing means comprises a rotatable sealing roller (33) in contact with the path-defining roller (26) along its length.

5. A method according to claim 4, wherein the sealing roller (33) is carried by a longitudinal bearing (34) constituting a stationary sealing member.

6. A method according to any preceding claim wherein the treatment cell further contains liquid level control means (36) to define a static liquid level (S) above the material path.

7. A method according to any preceding claims, wherein the housing (16) includes a treatment liquid circulation passage (24) .

8. A method according to any preceding claims, wherein the housing (16) includes means (44) to facilitate depressurising said cell.

9. A method for making a laminate comprising the steps of
- cleaning and transporting a first web- or sheet-like material from an outside environment into a clean room using a method according to any preceding claim;
- cleaning and transporting a second web- or sheet-like material from an outside environment into said clean room using a method according to any preceding claim;
- laminating said first material to said second material inside said clean room.

10. Use of a method according to any of the preceding claims during the manufacturing of a semiconductor device.
